Europäisches Patentamt

European Patent Office

Office européen des brevets

(11) Publication number: **0 441 398 A2**

# EUROPEAN PATENT APPLICATION

(21) Application number: **91101782.0**

(22) Date of filing: **08.02.91**

(51) Int. Cl.5: **G02F 1/13**

(30) Priority: **09.02.90 JP 31244/90**
**29.03.90 JP 78651/90**

(43) Date of publication of application:
**14.08.91 Bulletin 91/33**

(84) Designated Contracting States:
**DE FR GB**

(71) Applicant: **CASIO COMPUTER COMPANY LIMITED**
**6-1, 2-chome, Nishi-Shinjuku**
**Shinjuku-ku Tokyo(JP)**

(72) Inventor: **Wakisaka, Shinji, c/o Pat. Dep. Development Div.**
**Hamura R&D Cent. CASIO COMP.CO.LTD**
**3-2-1 Sakae-cho**
**Hamura-machi, Nishitama-gun,**
**Tokyo190-11(JP)**

(74) Representative: **Patentanwälte Grünecker, Kinkeldey, Stockmair & Partner**
**Maximilianstrasse 58**
**W-8000 München 22(DE)**

(54) **Display panel unit.**

(57) Disclosed is a matrix liquid crystal display panel unit which enables to decrease a useless space (A) around the real display area. The unit comprises a liquid crystal display panel (20), a holder (21) for carrying the display panel (20), a circuit board (23) disposed under the holder (21) and, at least, a pair of IC packages (22-1, 22-2) each having a wiring board (4) and an IC chip (7). The display panel (20) includes an upper electrode plate (25) with a first edge and a lower electrode plate (26) with a second edge (26b), and is provided with an intersection (A) where the first and second edges (25a, 26b) are crossing. One (22-1) of the IC packages is disposed along the first edge (25a), the other (22-2) along the second edge (26b), respectively, in the vicinity of the intersection (A). Each of the wiring boards (23) of the IC packages (22-1, 22-2) has an oblique edge (33) which gradually goes away to each other in the direction to the circuit board (23).

FIG.3

## DISPLAY PANEL UNIT

The present invention relates to a unit of a matrix display panel such as a liquid crystal display panel, etc.

In the matrix display panel unit, a carrier tape package is sometimes used for connecting a liquid crystal display panel and a control circuit board. The carrier tape package is manufactured by gang-bonding IC chips for driving a liquid crystal panel to a number of finger leads formed at plural areas continually on an insulating tape and by cutting these areas off from the tape. This manufacturing method is called as a TAB (Tape Automated Bonding) method. Since such matrix display panel unit uses the carrier tape packages manufactured by the TAB method, the productivity of the matrix display panel units is very high so that the price of them is very low. In the matrix display panel unit of the above-described type, the IC chips can be arranged on the side surface side or the back surface side of the liquid crystal display panel, so that wiring patterns on the control circuit board can be made simple and the whole of the matrix display panel unit can be made compact.

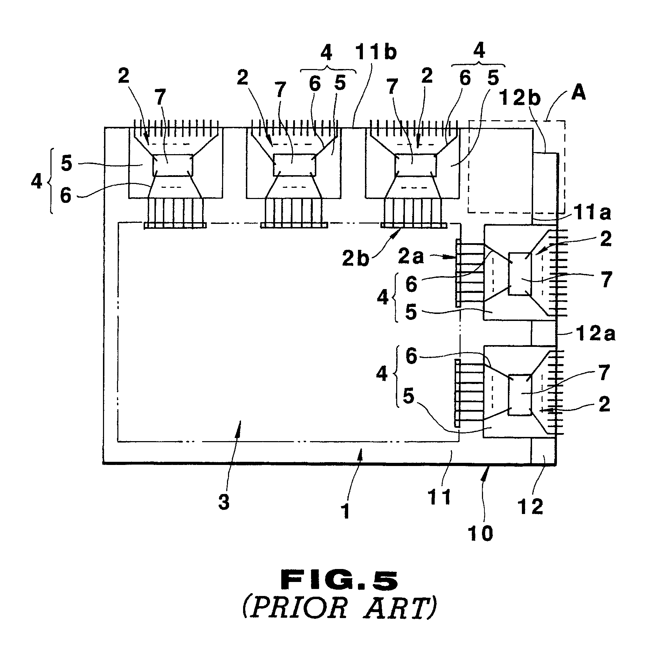

Fig. 5 shows the back view of a conventional matrix display panel unit 1 in which a liquid crystal display panel 10 and a control circuit board 3 are connected to each other by carrier tape packages 2. The liquid crystal display panel 10 is constructed by sealing liquid crystal between an upper electrode substrate 12 having column electrodes (not shown) and a lower electrode substrate 11 having row electrodes (not shown). A right edge portion 12a of the upper electrode substrate 12 is projected rightward from a right edge portion 11a of the lower electrode substrate 11, and column electrode terminals (not shown) as a part of column electrodes are formed on the back surface of the right edge portion 12a. An upper edge portion 11b of the lower electrode substrate 11 is projected upward from an upper edge portion 12b of the upper electrode substrate 12, and row electrode terminals (not shown) as a part of row electrodes are formed on the front surface of the upper edge portion 11b. Two carrier tape packages 2 are arranged along the back surface of the right edge portion 12a of the upper electrode substrate 12 and three carrier tape packages 2 are arranged along the back surface of the upper edge portion 11b of the lower electrode substrate 11. Each carrier tape package 2 has a carrier tape 4 and an IC chip 7 for driving a liquid crystal panel 10. The carrier tape 4 is composed of an insulating film 5 and wiring leads 6. The IC chip 7 is gang-bonded to one ends of the wiring leads 6 of the carrier tape 4. The manufacturing method of this carrier package 2 is well known as the TAB method. One ends of the wiring leads 6 for outputting display signals are extended to one end side of each carrier tape package 2 and bonded to the column electrode terminals of the upper electrode substrate 12 or to the row electrode terminals of the lower electrode substrate 11, while the other ends of the wiring leads 6 for inputting control signals are extended to the other end side of each carrier tape package 2 and bonded to connection terminals (not shown) of the control circuit board 3.

In the conventional matrix display panel unit described above, neither the column electrode terminals of the upper electrode substrate 12 nor the row electrode terminals of the lower electrode substrate 11 could be formed at a corner region A (Fig. 5) which is periphery around a spot where the right edge portion 12a of the upper electrode substrate 12 and the upper edge portion 11a of the lower electrode substrate 11 are crossed each other. This is because the other ends 2a and 2b of the inputting wiring leads 6 of the two carrier tape packages 2 located adjacent to the corner region A on the right and upper edge portions 12a and 11b of the upper and lower electrode substrates 12 and 11 have to be prevented from being overlapped to each other on the circuit board 3.

Namely, in the conventional matrix display panel unit 1, the corner region A as an useless space is inevitably needed, and it causes the front area of the display panel to enlarge.

It is therefore, an object of the present invention is to provide a compact matrix display panel unit.

This object of the present invention is achieved by a matrix display panel unit comprising:

a display panel having a first edge portion, second edge portion in the orthogonal direction to the first edge portion, a plurality of column electrode terminals arranged on the first edge portion and a plurality of row electrode terminals arranged on the second edge portion, the display panel having a corner region where the first and second edge portions are crossing; a first IC package mounted on the display panel along the first edge portion in the vicinity of the corner region; and a second IC package mounted on the display panel along the second edge portion in the vicinity of the corner region, the first and second IC packages including flexible wiring boards and IC chips, at least one of the flexible wiring boards having a diagonal cut-out portion at the position opposing the corner region.

This invention can be more fully understood from the following detailed description when taken in conjunction with the accompanying drawings, in which:

Fig. 1 is an enlarged longitudinal sectional view showing a main portion of a matrix display panel unit according to a first embodiment of the present invention;

Fig. 2 is a front side view schematically showing a whole of the matrix display panel unit of the first embodiment;

Fig. 3 is a back side view showing the whole of the matrix display panel unit of the first embodiment, wherein the matrix display panel unit is turned upside down, directing its upper edge downward and its lower edge upward;

Fig. 4 is a back side view showing a whole of a matrix display panel unit according to a second embodiment of the present invention; and

Fig. 5 is a back side view scematically showing the conventional matrix display panel unit.

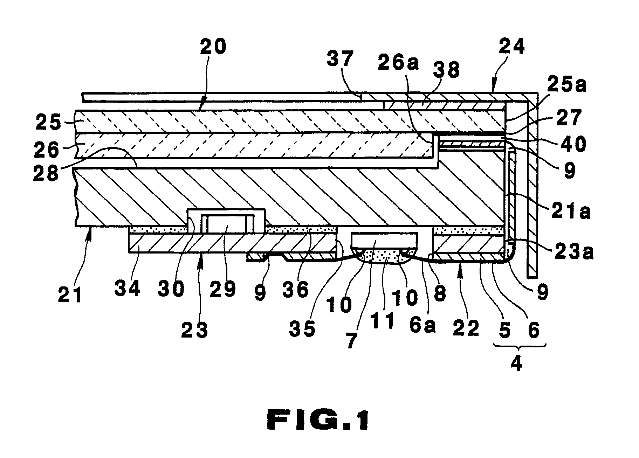

First and second embodiments of the present invention will be described in detail with reference to Figs. 1 through 4.

Figs. 1 through 3 show a matrix display panel unit according to a first embodiment of the present invention. The unit is constructed as a module such that a liquid crystal display panel 20, a holder 21, a plurality of carrier tape packages 22, a circuit board 23 and a metal-made frame 24 are integrally combined all together.

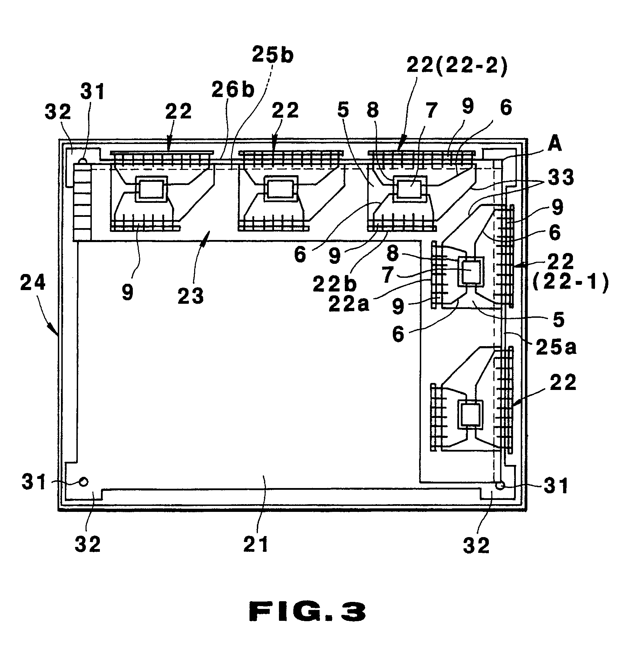

The liquid crystal display panel 20 is constructed by sealing liquid crystal material (not shown) between a pair of upper and lower electrode substrates 25 and 26 made of transparent glass or resin film and arranged parallel to each other. Transparent column and row electrodes are formed respectively on facing surfaces of the upper and lower electrode substrates 25 and 26, thereby constructing the matrix display panel. As shown in Fig. 1, a right edge portion 25a of the upper electrode substrate 25 is projected rightward from a right edge portion 26a of the lower electrode substrate 26, and column electrode terminals 27 are arranged on the back surface (or lower surface) of the right edge portion 25a of the upper electrode substrate 25. As shown in Fig. 3, a lower edge portion 26b of the lower electrode substrate 26 is projected upward from a lower edge portion 25b of the upper electrode substrate 25, and row electrode terminals (not shown) are arranged on the front surface of the lower edge portion 26b of the lower electrode substrate 26.

The holder 21 is formed of synthetic resin to have a substantially square flat outline. As shown in Fig. 1, a panel mounting portion 28 for storing the liquid crystal display is formed on the front side of the holder 21, and on the back side, legs 32 each having a screw hole 31, as shown in Fig. 3, are integrally formed at four corners of the holder 21.

Each carrier tape package 22 includes a wiring board 4 and an IC chip 7 for driving a liquid crystal panel. The wiring board 4 is provided with an insulating film 5 on which wiring leads 6 have been printed in a predetermined pattern, and the IC chip 7 is gang-bonded to inner ends 6a of the wiring leads 6, as shown in Fig. 1. The circuit board 23 has an inverted L shape extended along the lower edge portion 26b of the lower electrode substrate 26 and along the right edge portion 25a of the upper electrode substrate 25. Three carrier tape packages 22 are mounted on the circuit board 23 being arranged along the lower edge portion 26b, and two carrier tape packages 22 are mounted on the circuit board 23, along the right edge portion 25a, as shown in Fig. 3. Extended ends of the input wiring leads 6 of each of the carrier tape packages 22 are electrically bonded their corresponding terminals (not shown) of the control circuit board 23. Extended ends of the output wiring leads 6 of each of the carrier tape packages 22 are electrically bonded to the column or row electrode terminals formed on the right and lower edge portion 25a, 26b of the upper or lower electrode substrate 25, 26 of the liquid crystal display panel 20.

As shown in Figs. 1 and 3, a square shaped opening 8 is formed in the center of the insulating film 5. Each insulating film 5 further has slits 9 which are formed across entire width of the film 5 at portions adjacent to the extended ends of input and output wiring leads 6 and at middle portion between the inner ends 6a of output leads 6 and the extended ends thereof. Input and output wiring leads 6 are bridging over slits 9. The IC chip 7 is placed in the opening 8 of the insulating film 5, and each bump electrode 10 of the IC chip 7 is connected to the inner ends 6a of each of the wiring leads 6 which is extended into the opening 8. The front portion of the IC chip 7 including connection portions to the inner ends 6a is covered by a protective resin 11, as shown in Fig. 1. The output leads 6 of the carrier tape package 22 is bent along the slit 9, which is formed at portion between the inner ends 6a and the extended ends. So that the middle portion of the insulating film 5 can be laid along the side surface of the holder 21. The output leads 6 are also bent along the slit 9, which is formed at portion adjacent to the extended ends of the output wiring leads 6, so that the distal end portion of the insulating film 5 can be laid along the edge portion of the front side of the holder 21. At the edge portion, the extended ends of the output wiring leads 6 are opposed to the back surface of the right edge portion 25a of the upper electrode substrate 25 or the front surface of the lower edge portion 26b of the lower electrode substrate 26, and connected to their corresponding column electrode terminals on the right edge portion 25a or to their corresponding row electrode terminals on the lower edge portion 26b.

An important characteristic of the carrier tape package 22 resides in that one corner of the insulating film 5 is obliquely cut off, as shown in Fig. 3. In other words, the insulating film 5 is shaped like an irregular pentagon having an oblique side 33.

In the following description, one of the two carrier tape packages 22, which is arranged along the right edge portion 25a of the upper electrode substrate 25 and located adjacent to the corner region A, will be designated by reference numeral 22-1, and one of the three carrier tape packages 22, which is arranged along the lower edge portion 26b of the lower electrode substrate 26 and located adjacent to the corner region A, will be designated by reference numeral 22-2. The two adjacent carrier tape packages 22-1, 22-2 are respectively disposed on the wiring board 4 making the oblique sides 33 of insulating films 5 to face toward the corner region A, that is, to oppose to each other. Therefore, in the periphery of the corner region A, both carrier tape packages 22-1 and 22-2 can be arranged closer to each other than in the aforementioned conventional case. Needless to say, the extended ends of the input wiring leads 6 on both carrier tape packages 22-1 and 22-2 are not overlapped to each other. Since the corner region A which was conventionally left useless can be made extremely smaller, the whole front area of the matrix display panel unit 24 of the present invention is completed more compact.

The circuit board 23 is constructed by forming wiring leads of metal foil on the front and back surfaces of a base formed of an insulating film or hard resin board, etc. The circuit board 23 has a plurality of through-holes 35 for storing a plurality of IC chips 7 of carrier tape packages 22, as shown in Fig. 1. Electronic parts 29 such as the condensers, etc. are mounted on the circuit board 23, and the electronic parts 29 are placed in dent portions 30 formed in the back surface of the holder 21. Dent portions 30 may be formed by through-holes. IC chips (not shown) for controlling the IC chips 7 can be mounted on the circuit board 23. The circuit board 23 with the electronic parts 29 being mounted thereon is fixed to the back surface of the holder 21 by an adhesive 36 at a position where its distal end side surfaces 23a are correctly aligned with corresponding peripheral side surfaces 21a (that is, lower and right end surfaces) of the holder 21. If the distal end side surfaces 23a of the circuit board 23 is projected out from its corresponding peripheral side surfaces 21a of the holder 21, the output wiring leads 6 bridging over the slit 9 of each of the insulating film 5 can be easily broken by the edge of the distal end side surfaces 23a of the circuit board 23. To the contrary, if the distal end side surfaces 23a of the circuit board 23 is located inward from its corresponding peripheral side surfaces 21a of the holder 21, a space equivalent to a thickness of the wiring board 4 rises. Portion of output wiring leads 6 facing this space are not supported by the insulating film 5. These non-supported portions of the each insulating film 5 are deformed while the matrix display panel units are assembling or transporting, thereby causing the output wiring leads 6 to be broken.

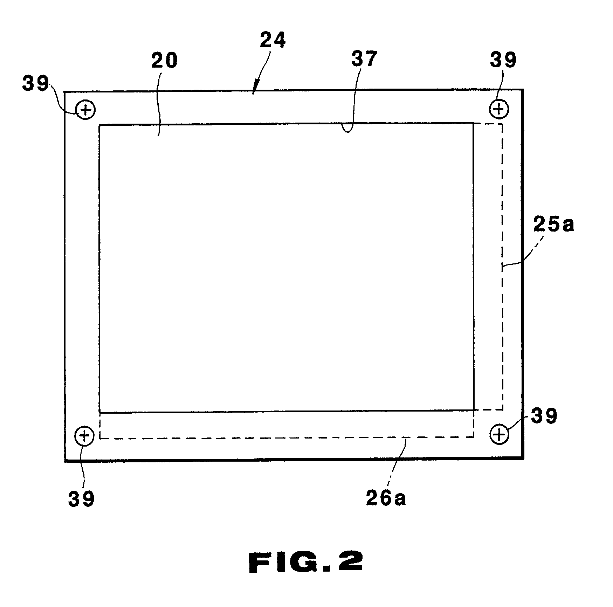

The metal frame 24 serves to protect and fix the above-described liquid crystal display panel 20, holder 21, carrier tape packages 22 and circuit board 23 one another. An opening 37 is formed in the frame 24 so as to correspond to the display area of the liquid crystal display panel 20, and a circumferential edge portion of the frame 24 is bent toward the back side, as shown in Fig. 1. The frame 24 is mounted on the liquid crystal panel 20 with a buffer rubber 38 covering the peripheral edge portion of the liquid crystal panel 20 to which carrier tape packages 22 and circuit board 23 have been previously coupled and which has been previously carried by the holder 21. The frame 24 and the holder 21 are formed into a module by screwing screws 39 at the four corners of the holder 21 into the screw holes 31 of the legs 32, as shown in Fig. 2.

It will be now described how the liquid crystal display panel 20, the holder 21, the carrier tape packages 22 and the circuit board 23 enclosed by the bent peripheral edge portion of the frame 24 are coupled one another.

The extended ends of the output wiring leads 6 of the carrier tape packages 22 are bonded to the corresponding column electrode terminals 27 on the back surface of the right edge portion 25a of the upper electrode substrate 25 of the liquid crystal display panel 20 and the corresponding row electrode terminals on the front surface of the lower edge portion 26b of the lower electrode substrate 26 thereof by using an electrically conductive bonding agent 40. The conductive bonding agent 40 is formed by mixing conductive fine particles into an insulating adhesive, and it has conductivity only in its thickness direction but has insulation in its plane direction when it is adhered on something by the thermocompression bonding or the like. The conductive fine particles are made of metal, carbon or the like. The fine particles can also be made by forming an insulating layer which is partly broken during thermocompression bonding, on conductive or non-conductive fine particles. By using this bonding agent 40, the column and row electrode terminals of the liquid crystal display panel 20 are bonded easily to the extended ends of the output wiring leads 6 of the carrier tape packages 22. By way of using the conductive bonding agent 40, solder or the like may be used.

The liquid crystal display panel 20 is then mounted on the panel mounting portion 28 of the front side of the holder 21, and the circuit board 23 is bonded to a predetermined portion on the back surface of the holder 21 by an adhesive 36. At this time, the distal end side surfaces 23a of the circuit board 23 is aligned with its corresponding peripheral side surfaces 21a of the holder 21, as described above. And, electronic parts 29 on the front surface of the circuit board 23 are placed in the dent portions 30 of the back side of the holder 21 so that the electronic parts 29 can be thus protected from outer force. In addition, the whole thickness of the unit can be reduced to the extent of the thickness of the parts 29.

In the next stage, the insulating film 5 of each of the carrier tape packages 22 is bent at the two slits 9 which the output wiring leads 6 are crossing over, whereby the distal end portion of the insulating film 5 faces the front edge surface of the holder 21 and the middle portion of the insulating film 5 faces the side surface of the holder 21. Further, the remaining portion of the insulating film 5 including the IC chip 7 and the input wiring leads 6 faces the back surface of the circuit board 23. The extended ends of the input wiring leads 6 are then connected to their corresponding terminals (not shown) of the wiring leads on the back surface of the circuit board 23. This connection is also achieved by using the conductive bonding agent 40, solder or the like. The IC chip 7 of each of the carrier tape packages 22 is stored in the corresponding through-hole 35 of the circuit board 23, thereby the whole thickness of the unit is reduced to such an extent that equals to the thickness of the IC chip 7.

Each of the carrier tape packages 22 is bent along the slits 9 of the insulating film 5. This makes it easier to bend the insulating film 5 at a small curvature and prevents excessive force from applying to the leads 6 at the time of this bending so that the wiring leads 6 is prevented from being broken.

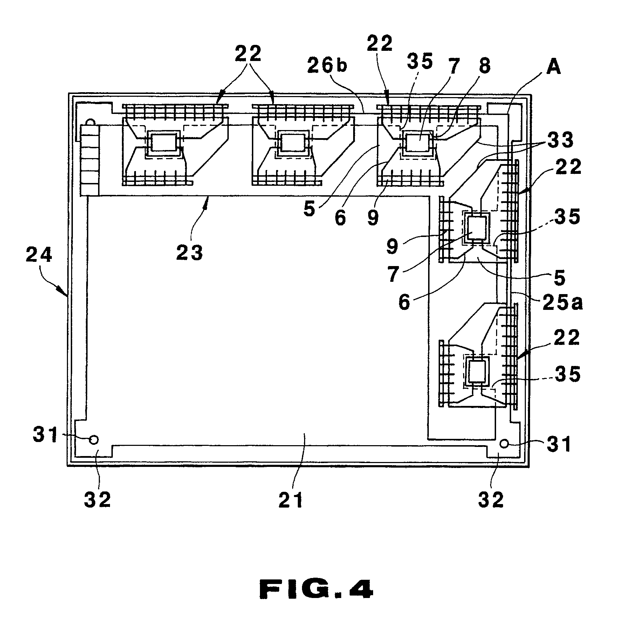

It should be understood that the present invention is not limited to the above-described embodiment. As shown in Fig. 4, for example, the indent portions 35, mounted in the circuit substrate 23 so as to house the IC chips 7 of the carrier tape packages 22, can be constructed by forming cutaway portions in the edge portion of the circuit substrate 23. Further, each of the insulation films 5 of the carrier tape packages 22 may be variously shaped to make smaller that area of the corner region A which is left useless.

## Claims

1. A display panel unit, comprising:

   a display panel (20) having a first edge portion (25a), second edge portion (26b) in the orthogonal direction to said first edge portion (25a), a plurality of column electrode terminals arranged on said first edge portion (25a) and a plurality of row electrode terminals arranged on said second edge portion (26b), said display panel (20) having a corner region (A) where said first and second edge portions (25a, 26b) are crossing;

   a first IC package (22-1) mounted on said display panel (20) along said first edge portion (25a) in the vicinity of said corner region (A); and

   a second IC package (22-2) mounted on said display panel (20) along said second edge portion (26b) in the vicinity of said corner region (A), said first and second IC packages (22-1, 22-2) including flexible wiring boards (4) and IC chips (7), characterized in that

   at least one of said flexible wiring boards (4) has an oblique cut-out portion (33) at the position opposing said corner (A).

2. The display panel unit according to claim 1, characterized in that said display panel (20) includes a first electrode plate (25) having said first edge portion (25a) and a plurality of column electrode terminals, and a second electrode plate (26) having said second edge portion (26b) and a plurality of row electrode terminals.

3. The display panel unit according to claim 2, characterized in that said display panel unit further comprises a holder (21) for carrying said display panel (20).

4. The display panel unit according to claim 3, characterized in that said display panel unit further comprises a circuit board (23) to which said wiring boards (4) are electrically connected.

5. The display panel unit according to claim 3, characterized in that said circuit board (23) is fixed to said holder (21) by adhesive.

6. The display panel unit according to claim 5, characterized in that said circuit board (23) and said holder (21) have side edges (23a, 21a) which are aligned so as to form a single on the surface to each other.

7. The display panel unit according to claim 5, characterized in that said display panel unit further comprises an electronic part (29) mounted on said circuit board (23) and said holder (21) has a cavity (31) to accommodate said electronic part (29).

8. The display panel unit according to claim 5, characterized in that said circuit board (23) has a cavity (35) to accommodate said IC chip (7).

9. The display panel unit according to claim 5, characterized in that said flexible wiring board (4) comprises an insulating flexible board (5) and a plurality of electric conductive leads (6).

10. The display panel unit according to claim 9, characterized in that said insulating flexible board has two slits (9) formed in the orthogonal direction to said electric conductive leads (6).

11. The display panel unit according to claim 10, characterized in that said display panel (20) is a liquid crystal display panel.

12. A liquid crystal display panel unit, comprising:
   a liquid crystal panel (20) including an upper electrode plate (25) having a first (25a) edge and column electrodes, and a lower electrode plate (26) having a second edge (26b) and row electrodes in the orthogonal direction to said row electrodes, said liquid crystal panel (20) being provided with an intersection (A) at the portion where said first edge (25a) of said upper electrode plate (25) and said second edge (26b) of said lower electrode plate (26) are crossing;
   a holder (21) having front side and rear side and carrying said liquid crystal display panel (20) on said front side;
   a circuit board (23) disposed on said rear side of said holder (21); and
   a pair of IC packages (22-1, 22-2), each having a flexible wiring board (4) and an IC chip (7) for connecting said electrodes of said liquid crystal display panel (20) to said circuit board (23), one (22-1) of said IC packages disposed along said first edge (25a) of said upper electrode plate (25) in the vicinity of said intersection (A) and the other (22-2) along said second edge of said lower electrode plate (26) in the vicinity of said intersection (A), characterized in that
   each of said wiring boards (4) of said IC packages (22-1, 22-2) has an oblique edge (33) which gradually goes away to each other in the direction to said circuit board (23).

**FIG.1**

**FIG. 2**

**FIG.3**

**FIG.4**

# FIG.5
## (PRIOR ART)